# EUROPEAN PATENT APPLICATION

(11) **EP 2 922 209 A1**
(43) Date of publication of application: **23.09.2015**
(21) Application number: 14160838.0
(22) Date of filing: 20.03.2014
(51) Int. Cl.: H03M 13/00, H03M 13/45, H03M 13/37, H03M 13/11, H03M 13/15, H03M 13/29

(54) **Soft decision decoding of linear block codes**

(71) Applicant: Technische Universität Kaiserslautern, 67663 Kaiserslautern (DE)
(72) Inventor: Scholl, Stefan, 67655 Kaiserslautern (DE)
(74) Representative: Herzog, Fiesser & Partner Patentanwälte PartG mbB

(57) **Abstract**

The present invention relates to a method and a device for an error correction of transmitted data. For this purpose, the transmitted data are encoded in a block code, wherein the block code comprises a number of data bits and an additional number of redundant bits. Herein the block code is described by a parity-check matrix H, wherein columns of the parity-check matrix H are inherently related to the data bits of the block code.

The method according to the present invention comprises the following steps:
(a) diagonalizing the parity-check matrix H, with respect to at least one column of the parity-check matrix H, into a diagonalized parity-check matrix H', wherein the diagonalized parity-check matrix H' is related to the block code and to the at least one column;
(b) determining at least one error position (130) in the block code by using the diagonalized parity-check matrix H' and a syndrome vector, wherein the syndrome vector is related to the data bits in the block code;
(c) performing the error correction of the transmitted data at the at least one error position (130) in the block code.

The present method and device allow providing communication channels with increased reliability and enhanced correction capability at reduced complexity, and is generally applicable to all known block codes, such as turbo, LDPC, BCH, or Reed-Solomon codes.

## Description

### Field of the invention

The present invention relates to a method and to a device as well as to a use of a device for an error correction of transmitted data, wherein the transmitted data are encoded in a block code, wherein the block code comprises a number of data bits and an additional number of redundant bits, wherein the block code is described by a parity-check matrix **H,** wherein columns of the parity-check matrix **H** are related to the data bits of the block code. The invention further relates to a computer program for performing the mentioned method as well as to a data carrier having a data structure stored thereon, which, after loading into a computer or a computer network, is capable of executing the method according to the present invention.

### Related art

Digital communication systems according to the state of the art are capable of transmitting data in form of data bits from a first location to a second location. However, at least one error may occur during a data transmission from a transmitter as being located at the first location to a receiver as being located at the second location, owing to a fact that the data transmission is, in practice, performed via a transmission channel, which comprises a transmission medium, such as air or a wire, wherein the transmission medium may be unreliable subject to noise and/or other disturbances and may be, thus, produce at least one erroneous data bit, i.e. a data bit which may be different in the receiver with respect to the transmitter. As a result, error correction methods and devices have been developed for many years, which are configured for recognizing and/or correcting, during a decoding procedure, the at least one error which may have occurred as a result of the actual data transmission via the transmission channel.

In order to enable a reliable error correction, the transmitted data are usually encoded in a channel code. In general, a channel code comprises a number of data bits, which are generally arranged in form of a linear code, and an additional number of redundant bits, wherein the redundant bits are determined according to a predefined definition. In the digital communication systems according to the state of the art, the data transmission is usually performed in a manner that, in the transmitter, the redundant bits are added to the data bits, such as appended or affixed to the linear arrangement of the data bits, and that, in the receiver, after having recovered both the data bits and the redundant bits, the redundant bits, within the decoding procedure, are employed for correcting the at least one error occurring within the received data bits in order to recover the original data bits as provided by the transmitter. Within this regard, the main challenge of the decoding procedure comprises actually determining at least one error position within the data bits of the channel code for correcting an erroneous transmitted data bit at this error position.

Usually, sophisticated algorithms are required to perform the decoding procedure in the channel code, wherein the data bits as received at an input of the receiver are generally equipped with reliability information related to each data bit. For this purpose, preferably a block code is applied, wherein the block code constitutes a specific channel code which can be described by a parity-check matrix **H,** wherein columns of the parity-check matrix **H** are related to the data bits of the channel code. In a number of known decoding algorithms, at least one column of the parity-check matrix **H** is diagonalized into a diagonalized parity-check matrix **H',** wherein the diagonalized parity-check matrix **H'** is related to the block code and to the at least one column. In some of the known algorithms, at least one error position in the block code is assigned to one of a type I error position and a type II error position, wherein the type I error position is located within the diagonalized part of the diagonalized parity-check matrix **H',** and wherein the type II error position is located within the non-diagonalized part of the diagonalized parity-check matrix **H'.**

As particular examples, EP 1 689 085 A2 and US 2008/0168333 A1 each describe a method and a device for the error correction of transmitted data, wherein the diagonalized parity-check matrix **H'** is employed for eventually determining the error positions within the block code. However, this method is based on Adaptive Believe Propagation (ABP) which makes use of calculating sums with real and/or fixed point numbers and returning minimum values thereof which, therefore, require a separate storage device, and, thus, turn out to be rather complex. In addition, no evidence is given here how to treat multiple type II errors within the diagonalized parity-check matrix **H'.**

In addition to employing the diagonalized parity-check matrix **H',** A. Ahmed, N.R. Shanbhag, and R. Koetter, "An Architectural Comparison Of Reed-Solomon Soft-Decoding Algorithms", in Proc. Forthieth Asilomar Conf. Signals, Systems and Computers ACSSC '06, 2006, pp. 912-16, make use of a syndrome of the block code, wherein the syndrome of the linear block code is defined as a product of the received data bits with the parity-check matrix **H.** However, no evidence is given in this reference how the syndrome may be employed in determining the at least one error position within the data bits of the block code. Furthermore, no evidence is given here how to treat multiple type II errors within the diagonalized parity-check matrix **H'.**

In a similar manner, A. Ahmed, R. Koetter, and N.R. Shanbhag, "Performance Analysis Of The Adaptive Parity Check Matrix Based Soft-Decision Decoding Algorithm", in Proc. Conf. Signals, Systems and Computers Thirty-Eighth Asilomar Conf., Vol. 2, 2004, pp. 1995-99, employ the diagonalized parity-check matrix **H'** and the syndrome for the error correction, wherein a correlation between the columns of the diagonalized parity-check matrix **H'** and the syndrome is applied as a metrics. However, again no evidence for determining the at least one error position in the block code is given. In addition, a procedure as presented in this reference for correcting type II errors turns out to require a considerably enhanced computation time.

### Problem to be solved

It is therefore an objective of the present invention to overcome the drawbacks and shortcomings of known methods and devices for an error correction of transmitted data.

It is a particular objective of the present invention to provide a method and a device for an error correction of transmitted data which allow, with regard to known methods and devices according to the state of the art, correcting more errors in the transmitted data within a considerably reduced computation time. In particular, the method and the device for the error correction of the transmitted data should not only be applicable to a specific channel code and, preferably, allow a simple implementation as an electrical circuit.

It is a further objective of the present invention to provide a method and a device for an error correction of transmitted data which allows treating multiple type II errors within the diagonalized parity-check matrix **H',** particularly, within a considerably reduced computation time.

### Summary of the invention

This problem is solved by a method and a device as well as a use of a device for an error correction of transmitted data with the features of the independent claims. Preferred embodiments, which might be realized in an isolated fashion or in any arbitrary combination, are listed in the dependent claims.

As used in the following, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are actually present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, as used in the following, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

In a first aspect, the present invention relates to a method for an error correction of transmitted data. As used herein, the "transmitted data" may comprise an arbitrary linear arrangement of bits to be transmitted by a data transmission via a transmission channel from a first location to a second location, wherein the second location may usually be different from the first location. As further used herein, a "bit" may constitute a basic unit of information, wherein the bit can only take one of two binary values, wherein the binary values may be commonly represented by 'false' and 'true' or by '0' and '1'. Thereby, the linear arrangement of the bits comprises both a number of data bits and an additional number of redundant bits, wherein the redundant bits may be added, such as appended or affixed, to the linear arrangement of the data bits. Usually, the linear arrangement of the bits provided for the data transmission via the transmission channel may, thus, be denoted as a "channel code".

With respect to the present invention, the transmitted data are encoded in form of a "block code", wherein the block code constitutes a specific form of the channel code to the effect that the block code can be described by a parity-check matrix **H.** As a matrix, the parity-check matrix **H** comprises a number of columns, wherein the number of the columns equals the number of the data bits within the block code, wherein the columns are inherently related to the data bits of the block code.

The method according to the present invention comprises the following steps:
(a) diagonalizing the parity-check matrix **H,** with respect to at least one column of the parity-check matrix **H,** into a diagonalized parity-check matrix **H',** wherein the diagonalized parity-check matrix **H'** is related to the block code and to the at least one column;
(b) determining at least one error position in the block code by using the diagonalized parity-check matrix **H'** and a syndrome vector, wherein the syndrome vector is related to the data bits in the block code; and
(c) performing the error correction of the transmitted data at the at least one error position in the block code.

According to step (a), the parity-check matrix **H** is diagonalized into a diagonalized parity-check matrix **H',** wherein a diagonalization is performed with respect to at least one column *c* of the parity-check matrix **H.** As a result, the diagonalized parity-check matrix **H'** is related to both the block code and the at least one column *c.* As further used herein, a "matrix" may comprise a rectangular arrangement of the binary values arranged in rows and columns, wherein the "diagonalization" may describe a matrix operation after which the at least one column *c* of a diagonalized matrix can only comprises one 'true' or '1' value whereas all other values in the at least one column *c* are 'false' or '0' values, wherein different columns may differ from each other by the number of the row in which the one 'true' or '1' value may appear. In general, the diagonalization is usually performed by adding at least one column of the matrix to at least one further column of the matrix which, however, requires a complex and sophisticated storage access.

Therefore, the diagonalization of the the parity-check matrix **H** may preferably be performed by processing column by column. For this purpose, as, for example described in S. Scholl, C. Stumm, and N. Wehn, Hardware Implementations of Gaussian Elimination over GF(2) for Channel Decoding Algorithms, Proc. of IEEE AFRICON, 2013 , 9-12 Sept. 2013, the at least one column of the parity-check matrix **H** may be inserted step by step into a pipeline array, wherein, within each step, an addition may be performed row by row within each of the column vectors. In order to perform the addition, the steps may preferably be configured within a two-phase procedure. After transferring a respective column step by step through the complete pipeline array, the respective column may, eventually, be transformed into the respective column of the diagonalized parity-check matrix **H'.** Performing the diagonalization of the the parity-check matrix **H** in such manner may particularly be advantageous in a case in which more than one diagonalization may be required. Due to an effect that multiple diagonalizations may usually only differ within a few locations, a corresponding device wherein this method may be implemented may be configured in a manner that at least parts of a corresponding hardware architecture may be used several times, which may result in a less complex and/or sophisticated set-up of related electronic components as required for the hardware architecture.

In a particularly preferred embodiment, the at least one column *c* of the parity-check matrix H may be selected for the diagonalization according to a reliability information which may be related to the data bits of the block code, wherein the data bit which may be considered as a most unreliable data bit within the block code may preferably be selected. As further used herein, the "reliability information" may constitute a kind of information being related to a reliability of each of the data bits within the block code, wherein the term "reliability" may refer to an extent to which, after the data transmission, the transmitted data bits are identical with the data bits prior to the data transmission. In digital communication systems according to the state of the art, each of the data bits within the block code may usually be received with the corresponding reliability information attached to it.

According to step (b), at least one error position in the block code is determined using the diagonalized parity-check matrix **H'** and a syndrome vector. As used herein, the term "error position" may relate to a location within the block code at which the binary value of the respective data bit may be subj ect to an error owing to the data transmission via the actual transmission channel as described above. Since the block code is closely related to the diagonalized parity-check matrix **H',** the at least one error position within the diagonalized parity-check matrix **H'** may preferably be assigned to a type I error position or to a type II error position, wherein the type I error position is located within a diagonalized part of the diagonalized parity-check matrix **H',** and wherein the type II error position is located within a non-diagonalized part of the diagonalized parity-check matrix **H'.**

The syndrome vector **s** is related to the data bits in the block code by the effect that, in the linear arrangement of the block code, the syndrome vector **s** is defined as a binary XOR operation of the block code as received at the receiver with the parity-check matrix **H.** As further used herein, the binary XOR operation may be performed component-wise with respect to two components, thereby, in case of a positive binary XOR operation, returning a 'true' or '1' value for different components and a 'false' or '0' value for equal components, or, in case of a negative binary XOR operation, returning a 'true' or '1' value for equal components and a 'false' or '0' value for different components. Consequently, the syndrome vector **s** may only depend upon a possible error and not on the binary values of the block code itself. For example, the syndrome vector **s** may be equal to a zero vector **0** in a case in which no error may be present in the block code as received by the receiver.

On the other hand, if at least one error might be present in the block code, the syndrome vector **s** may return the at least one error position, at which the related binary value might be corrected in the subsequent step (c). As a particularly preferred embodiment according to the present invention, in step (b), the at least one type I error position may be determined by locating at least one 'true' or '1' entry within in the syndrome vector **s** which, thus, may return the at least one error position subject to error correction.

In a further preferred embodiment, in step (b), one, and exactly one type II error position may be determined by comparing the syndrome vector **s** with one particular column *c* of the diagonalized parity-check matrix **H'.** Preferably, the particular column *c* may selected from the at least one column of the diagonalized parity-check matrix **H'** in a manner that it may be considered as the column c whose binary values might be, with respect to the same position within both vectors, most similar to the binary values as comprised within the syndrome vector **s.**

Within this particular embodiment, at least one column *c* of the diagonalized parity-check matrix **H',** which may each be considered as at least one column vector **c,** and the syndrome vector **s** are, preferably, component-wise submitted to a binary XOR operation, thereby acquiring a resulting vector **r** for each column *c.* Subsequently, the resulting vectors **r** are weighted, in particular by a suitable logical element, such an adder tree, which might be configured for determining how many true or '1' binary values may be comprised within each resulting vector **r.** Hereby, the sum within each resulting vector **r** may be considered as a weight of the respective resulting vector **r.** Thereafter, in case of a positive binary XOR operation; a minimum of the weights of the resulting vectors **r** may be determined, wherein the minimum may return the desired type II error position. Since the positive binary XOR operation as performed above returns a 'true' or '1' value for different components and a 'false' or '0' value for equal components, the positive binary XOR operation may be particular adapted for this purpose as it returns the zero vector **0** for two identical vectors.

In an alternative embodiment, the at least one column vector **c** of the diagonalized parity-check matrix **H'** and the syndrome vector **s** may, preferably, be component-wise submitted to a negative binary XOR operation. Since the negative binary XOR operation returns a 'true' or '1' value for equal components and a 'false' or '0' value for different components, in a similar manner as described above, a maximum of the weights of the resulting vectors **r** may be determined, wherein, in this particular embodiment, the maximum may return the desired type II error position.

In a further preferred embodiment, in step (b), at least one type II error position, preferably more than one type II error positions, may be determined by storing at least one column, preferably more than one column, of the diagonalized parity-check matrix **H'** as at least one stored column and comparing the syndrome vector with the at least one stored column. Alternatively or in addition, it may be preferable to store at least one sum of at least one column, preferably more than one column, of the diagonalized parity-check matrix **H'** with the syndrome vector as at least one stored column, and/or to store at least one sum of at least two columns of the columns of the diagonalized parity-check matrix **H'** as at least one stored column. In particular, both the storing of more than one stored column and the comparing of the syndrome vector with the at least one stored column may be performed simultaneously, which may result in a considerable enhancement of the computation time as required for determining more than one type II error positions within the parity-check matrix **H.**

In a further preferred embodiment, in step (a), at least two different kinds of diagonalizations of the diagonalized parity-check matrix **H'** may be provided, in particular by using at least two different columns c of the parity-check matrix **H,** for determining, in step (b), at least one, preferably at least two error positions. Depending on the selected column *c* of the parity-check matrix **H** for actually diagonalizing the parity-check matrix **H,** with respect to the selected column *c* of the parity-check matrix **H,** into the diagonalized parity-check matrix **H',** the specific error position accordingly determined may be found to be one of a type I error position within one diagonalization and a type II error position within another diagonalization, depending whether the specific error position is located within the diagonalized or the non-diagonalized part of the diagonalized parity-check matrix **H'.** Since more type I error positions, compared to type II error positions, may be corrected within a given period of time, the correction capability of the present method may, therefore, be considerably enhanced.

According to step (c), the error correction of the transmitted data is performed at the at least one error position in the block code as determined by step (b). Hereby, the error correction of the transmitted data may preferably be performed by inverting the data bit at the at least one error position in the block code, i.e. by switching a binary 'false' or '0' value to a binary 'true' o '1' value or, vice versa, by switching a binary 'true' o '1' value to a binary 'false' or '0' value.

In a further aspect, the present invention relates to a device for an error correction of transmitted data, wherein the transmitted data are encoded in a block code, wherein the block code comprises a number of data bits and an additional number of redundant bits, wherein the block code is described by a parity-check matrix **H,** wherein columns of the parity-check matrix **H** are related to the data bits of the block code. According to the present invention, the device comprises at least parts (A) to (C), which may be located within any suitable arrangement. Further, additional parts may be comprised within the device which are not mentioned in the following. The parts (A) to (C) may be part of one combined or centralized apparatus or may be combined in different or de-centralized units, wherein the units may be adapted to interact with each other in any suitable fashion, such as by wire-bound and/or wireless communication and/or storage. In particular, the device may be adapted for performing the method as described above and/or below.

Thus, the device according to the present invention comprises at least:
(A) a diagonalization unit for performing a diagonalization of at least one column of the parity-check matrix **H** of the block code into a diagonalized parity-check matrix **H';**
(B) an error detection unit for determining at least one error position in the block code by using the diagonalized parity-check matrix **H'** and a syndrome vector; and
(C) an error correction unit for performing the error correction of the transmitted data at the at least one error position in the block code.

For further details regarding the device, reference may be made to the disclosure of the method, as described above and/or below.

In a preferred embodiment, the error detection unit may comprise a look-up table for inserting at least one 'true' or '1' binary value of the syndrome vector. As further used herein, the "look-up table" may comprise an arbitrary arrangement of values, wherein an index is attached to each value. This arrangement may, thus, replace a runtime computation of a specific value with a simpler indexing operation related to finding and returning a value by the index attached to it. Herein, the at least one 'true' or '1' binary value within the look-up table may provide at least one type I error position located within the diagonalized part of the diagonalized parity-check matrix **H'.**

In a further preferred embodiment, the error detection unit may further comprise at least one XOR gate which may be adapted for a component-wise submitting of one of the at least one column vectors **c** of the diagonalized parity-check matrix H' and the syndrome vector **s** to a binary XOR operation in order to acquire at least one resulting vector **r,** at least one weighing unit for weighing the at least one resulting vector **r**, and at least one extremum determining unit for determining an extremum of the at least one weighted resulting vector **r,** wherein the extremum may provide a type II error position being located within the non-diagonalized part of the diagonalized parity-check matrix **H'.** More preferably, the XOR gate may be adapted for the component-wise submitting of the at least two column vectors **c** of the diagonalized parity-check matrix **H'** and the syndrome vector **s** to a binary XOR operation in order to acquire the at least two resulting vectors **r.** Herein, the weighing unit may be configured for weighing the least two resulting vectors **r,** whereas the extremum determining unit may be adapted for determining the extremum of the at least two weighted resulting vectors **r.**

In a further preferred embodiment, the error detection unit may further comprise at least one storage unit for storing at least one stored column, such as at least one column of the diagonalized parity-check matrix **H'** and/or at least one sum of at least one column of the diagonalized parity-check matrix **H'** with the syndrome vector and/or least one sum of at least two columns of the columns of the diagonalized parity-check matrix **H',** and at least one comparing unit for comparing the syndrome vector with the at least one stored column, wherein the comparing may provide the at least one type II error position. More preferably, the at least one storage unit may be adapted for storing the at least two columns of the diagonalized parity-check matrix **H'** as the at least two stored columns, whereas the at least one comparing unit may be configured for comparing the syndrome vector with the at least two stored columns, wherein the comparing may, thus, provide at least two type II error positions.

In a further aspect, the present invention relates to a use of the device for an error correction of transmitted data, wherein the data are transmitted by a communication system and/or wherein the data are transmitted to or from a storage system. As used herein, the "communication system" comprises one or more of a DSL (Digital Subscriber Line), a DAB (Digital Audio Broadcasting), a DVB (Digital Video Broadcasting), a satellite, a deep-space, an optical, and a mobile communication system, whereas the "storage system" comprises one or more of a hard disk, a flash disk, such as an USB (Universal Serial Bus) storage system, and an optical storage system. In addition, the method and the device for the error correction of the transmitted data according to the present invention may also be combined with known methods and devices, in particular in order to increase their capability of the correction of the errors within the transmitted data.

The invention further discloses and proposes a computer program including computer-executable instructions for performing the method according to the present invention in one or more of the embodiments enclosed herein when the program is executed on a computer or computer network. Specifically, the computer program may be stored on a computer-readable data carrier. Thus, specifically, one, more than one or even all of method steps (a) to (c) as indicated above may be performed by using a computer or a computer network, preferably by using a computer program.

The invention further discloses and proposes a computer program product having program code means, in order to perform the method according to the present invention in one or more of the embodiments enclosed herein when the program is executed on a computer or computer network. Specifically, the program code means may be stored on a computer-readable data carrier.

Further, the invention discloses and proposes a data carrier having a data structure stored thereon, which, after loading into a computer or computer network, such as into a working memory or main memory of the computer or computer network, may execute the method according to one or more of the embodiments disclosed herein.

The invention further proposes and discloses a computer program product with program code means stored on a machine-readable carrier, in order to perform the method according to one or more of the embodiments disclosed herein, when the program is executed on a computer or computer network. As used herein, a computer program product refers to the program as a tradable product. The product may generally exist in an arbitrary format, such as in a paper format, or on a computer-readable data carrier. Specifically, the computer program product may be distributed over a data network.

Finally, the invention proposes and discloses a modulated data signal which contains instructions readable by a computer system or computer network, for performing the method according to one or more of the embodiments disclosed herein.

Preferably, referring to the computer-implemented aspects of the invention, one or more of the method steps or even all of the method steps of the method according to one or more of the embodiments disclosed herein may be performed by using a computer or computer network. Thus, generally, any of the method steps including provision and/or manipulation of data may be performed by using a computer or computer network. Generally, these method steps may include any of the method steps (a) to (c) as indicated above.

The method and the device for an error correction of transmitted data according to the present invention provides a number of advantages with respect to the state of the art which may include a reduced transmitting power, smaller antennae, a longer battery usage, and a possible application of less sophisticated electronic components within the device. In particular, the present method and device may allow providing communication channels with increased reliability and enhanced correction capability at reduced complexity, which may be applicable to all known block codes, wherein the block code may comprise one of a turbo code, a LDPC (Low-Density-Parity-Check) code, a BCH (Bose-Chaudhuri-Hocquenghem) code, or a Reed-Solomon code. Hereby, considerably advantages may also be achieved for high-density parity-check codes, such as BCH or Reed-Solomon, for which the present invention may, thus, lead to a good performance at reduced complexity of the error detection and correction methods and devices involved. Within this regard, it may be mentioned that although some of the channel codes are non-binary codes, such as Reed-Solomon codes, non-binary turbo codes, or non-binary LDPC codes, since they work with groups of data bits instead of single data bits, the method according to the present invention may, nevertheless, be applicable to such a code after a well-known prior conversion of the respective non-binary code into one of the mentioned binary codes.

### Short description of the Figures

Further optional features and embodiments of the invention will be disclosed in more detail in the subsequent description of preferred embodiments, preferably in conjunction with the dependent claims. Therein, the respective optional features may be realized in an isolated fashion as well as in any arbitrary feasible combination, as the skilled person will realize. The scope of the invention is not restricted by the preferred embodiments. The embodiments are schematically depicted in the Figures. Therein, identical reference numbers in these Figures refer to identical or functionally comparable elements.

In the Figures:
- Figure 1: shows a schematic view of a preferred embodiment of a device being capable of an error correction of transmitted data according to the present invention;
- Figure 2: schematically depicts a preferred embodiment of an error detection unit configured for determining at least one error position;
- Figure 3: schematically depicts a further preferred embodiment of an error detection unit configured for determining at least one type II error position within the block code; and
- Figure 4: presents a further schematic view of a further preferred embodiment of the device according to the present invention, wherein at least two different kinds of diagonalizations of the parity-check matrix **H'** are employed for determining least two error positions within the block code.

### Detailed description of the embodiments

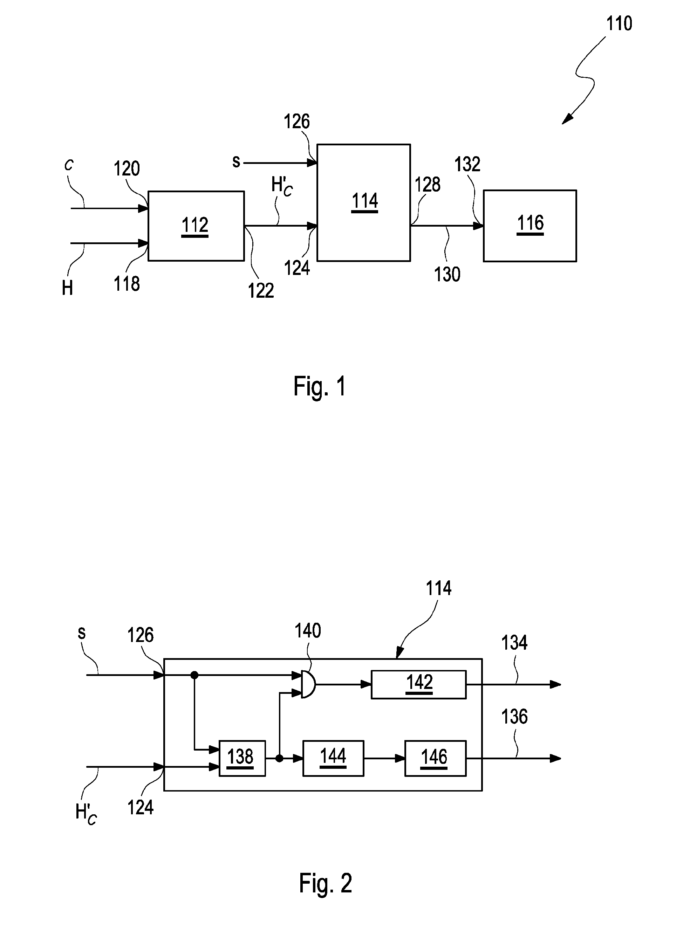

Figure 1 shows a schematic view of a preferred embodiment of an error correction device 110 being capable of an error correction of transmitted data according to the present invention. Herein, the transmitted data are encoded in a block code, wherein the block code comprises a number of data bits and an additional number of redundant bits, wherein the block code is described by a parity-check matrix **H,** wherein the parity-check matrix **H** comprises a number of columns *c* = *c₁, c₂, c₃,* ... *cₙ,* wherein 1, 2, 3 ..., n denotes the corresponding number of the respective column, wherein the respective columns are related to the data bits of the block code. In this particular embodiment, the error correction device 110 comprises three distinctive separate parts, i.e. a diagonalization unit 112, an error detection unit 114, and an error correction unit 116.

Herein, the diagonalization unit 112 is adapted for diagonalizing at least one column *c* of a parity-check matrix **H** according to step (a) of the related method into a diagonalized parity-check matrix **H'.** For this purpose, the diagonalization unit 112 comprises a first input port 118 and a second input port 120, wherein at the first input port 118 of the diagonalization unit 112 at least one column *c* the parity-check matrix **H** and at the second input port 120 of the diagonalization unit 112 the number related to the at least one column *c* of the parity-check matrix **H** are entered into the diagonalization unit 112. Herein, the at least one column *c* of the parity-check matrix **H** may be preferably selected according to a reliability information related to the data bits of the block code, wherein it may be preferably to select the data bit which is considered as most unreliable. At the output port 122 of the diagonalization unit 112, the at least one column *c* of the diagonalized parity-check matrix **H'** is provided for further use within the error detection unit 114.

Further, the error detection unit 114 comprises a first input port 124 and a second input port 126, wherein at the first input port 124 of the error detection unit 114 the diagonalized parity-check matrix **H'** as provided by the diagonalization unit 112 and at the second input port 126 of the error detection unit 114 a syndrome vector **s** are entered into the error detection unit 114. Herein, the error detection unit 114 is configured for determining at least one error position in the block code according to step (b) of the related method by applying the diagonalized parity-check matrix **H'** and a syndrome vector **s.** At the output port 128 of the error detection unit 114, at least one error position 130 in the block code is provided for further use within the error correction unit 116.

Finally, the error correction unit 116 comprises an input port 132 where the at least one error position 130 in the block code is entered into the error correction unit 116 for per-forming the error correction of the transmitted data according to step (c) of the related method at the at least one error position 130 in the block code as determined by the error detection unit 114. Hereby, the error correction of the transmitted data is performed within the error correction unit 116, in particular, by inverting respective the data bit at the at least one error position 130 within the block code.

Figure 2 schematically depicts a preferred embodiment of the error detection unit 114 which is configured for determining at least one error position 130 within the block code. Accordingly, at the first input port 124 of the error detection unit 114 the at least one column *c* of the diagonalized parity-check matrix **H'** as provided by the diagonalization unit 112 is entered into the error detection unit 114, whereas at the second input port 126 of the error detection unit 114 again the syndrome vector **s** is provided.

In addition to the embodiment of the error detection unit 114 as shown in Figure 1, the error detection unit 114 as depicted in Figure 2 is capable of determining at least one type I error position 134 and exactly one type II error position 136 within the block code. As already mentioned above, the at least one error position 130 in the block code may be assigned to one of a type I error position 134 and a type II error position 136, wherein the type I error position is located within the diagonalized part of the diagonalized parity-check matrix **H'** and the type II error position is located within the non-diagonalized part of the diagonalized parity-check matrix **H'.**

For this purpose, the error detection unit 114 comprises an XOR gate 138, i.e. a digital logic gate which implements a logical "exclusive or" function. Hereby, the logical "exclusive or" function works as a positive binary XOR operation which only provides a 'true' or '1' output result if one, and only one, of the input values into the gate is 'true' or '1' and the other is 'false' or '0'. On the other hand, if both of the input values are 'false' or '0' or if both of the input values are 'true' or '1', a 'false' or '0' output result will occur. Within this regard, the XOR gate 138 is employed for component-wise submitting a column vector **c** of the diagonalized parity-check matrix **H'** and of the syndrome vector **s** to a binary XOR operation. For this purpose, it may be required to further use the at least one number of the corresponding column in determining the at least one error position 130 within the block code.

The error detection unit 114 according to Figure 2 further comprises a multiplexer 140 which may be adapted for discriminating whether a particular error position in the block code may be assigned as type I error position 134 or as type II error position 136. According to a respective assignment, only the syndrome vector **s** may be used for the further determination, i.e. for determining the corresponding type I error position 134, or a sum of the vector **s** and the particular column of the diagonalized parity-check matrix **H',** i.e. for determining the corresponding type I and type II error positions 134, 136. For performing such a discrimination, a weight of the syndrome vector s may be used.

For determining the at least one type I error position 134 in the block code, the multiplexer 140 provides for each true or '1' entry within the syndrome vector s the respective index of the mentioned entry an entry into a look-up table 142. By performing such a look-up procedure, the look-up table 142 will then provide all of the at least one type I error position 134 which are comprised within the block code.

For determining the exactly one type II error position 136 within the block code, the error detection unit 114 according to Figure 2 further comprises a weighing unit 144 for weighing the results as acquired by the XOR gate 138. Herein, the weighing unit 144 may comprise a further logical element, such an adder tree, which is configured for determining a number of true or '1' entries within the column *c* of the diagonalized parity-check matrix **H',** thus, calculating the sum within the respective column *c,* which may be considered as a weight of the respective column *c.* In addition, a minimum determining unit 146 for determining a minimum of the weighted results is further comprised within the error detection unit 114 according to Figure 2. As already described above, the minimum determining unit 146 allows determining the specific column *cₙ* of the diagonalized parity-check matrix **H',** which exhibits the highest similarity with the syndrome vector **s,** by which result the exactly one type II error position 136 within the block code will be provided.

For determining, in particular simultaneously, more than exactly one type II error position 136 within the block code, a sum comprising more than one column *c* of the diagonalized parity-check matrix **H'** may be provided at the input port 124 of the error detection unit 114 according to Figure 2, wherein the sum which is most similar to the syndrome vector **s** may be selected as the at least two type II error positions 136 within the block code. However, particularly owing to a large number of possible combinations of the columns, this implementation is usually not very attractive since it may require an increased computation time for both the diagonalization and the error detection.

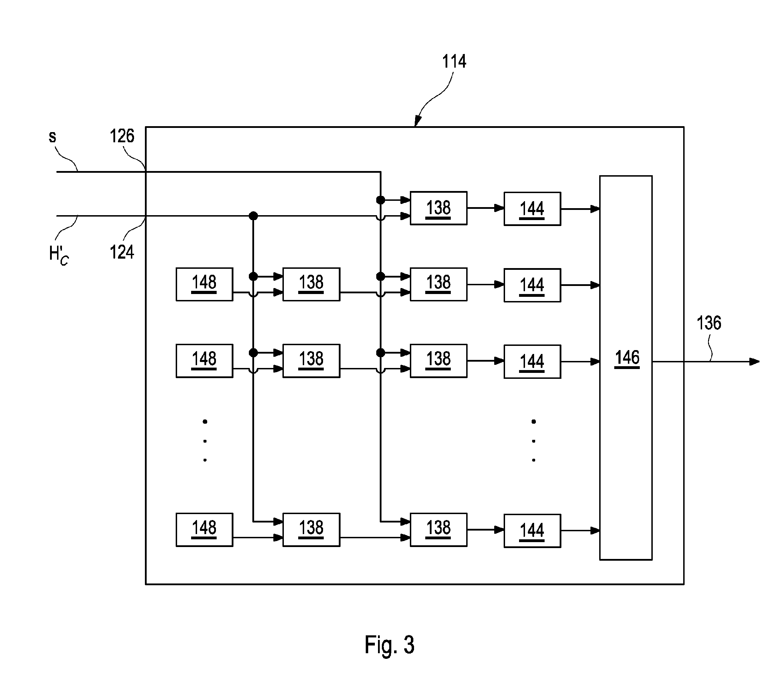

An alternative implementation for, in particular simultaneously, determining at least one type II error position within the block code is shown in Figure 3 which schematically depicts a further preferred embodiment of the error detection unit 114 being configured for performing this task. Herein, the error detection unit 114 additionally comprises at least one storage unit 148, preferably *n* ≥ *1* storage units 148 wherein *n* denotes the number of columns in the diagonalized parity-check matrix **H',** wherein each storage unit 148 is designated for storing one column *c* of the diagonalized parity-check matrix **H'** or, alternatively, for storing a sum of at least two columns of the diagonalized parity-check matrix **H'** or, as a further alternative, for storing a sum of at least one column of the diagonalized parity-check matrix **H'** with the syndrome vector **s.** Consequently, the sums of each column are, in particular simultaneously, calculated and analyzed within the at least one weighing unit 144 and the subsequent minimum determining unit 146 within the error detection unit 114. In particular, the calculation and analysis of the sums of each column in a parallel manner save a lot of computation time and, thus considerably enhances the performance in determining more than one type II error position 136 in the block code.

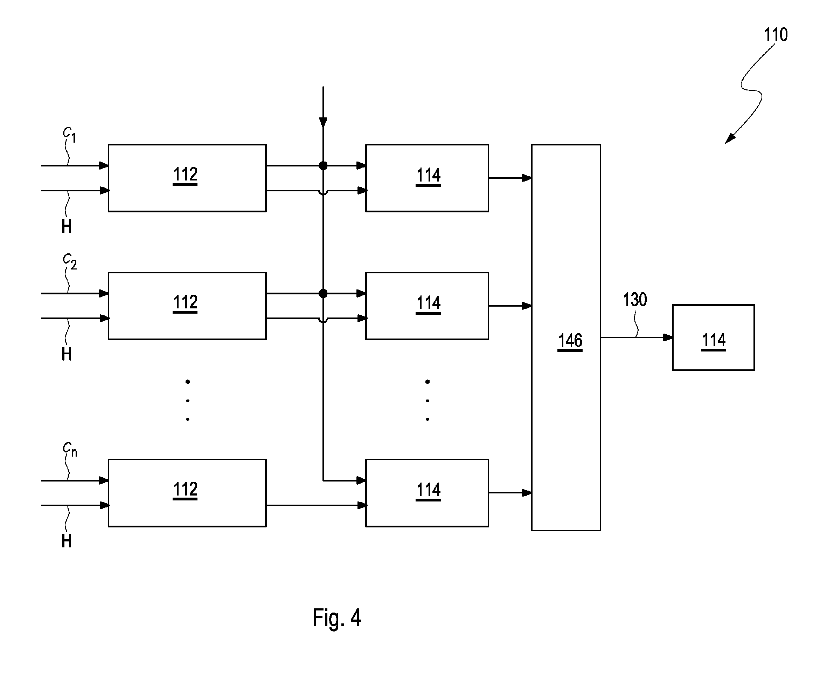

A further embodiment of the present invention which considerably reduces the computation time required for determining more than one error position 130 within the block code is schematically shown in Figure 4. Within this particular embodiment, not only one diagonalization unit 112 may be provided for diagonalizing one column *c* of the parity-check matrix **H** into the diagonalized parity-check matrix **H'** but rather *n* ≥ *1* diagonalization units 112, wherein each diagonalization unit 112 diagonalizes the parity-check matrix **H** into a specific diagonalized parity-check matrix **H_{c}'** which depends on the properties of the respective column *c* by using a different columns *cᵢ* = *c₁, c₂, c₃,* ... *cₙ* of the parity-check matrix **H.** Consequently, the error position 130 of a specific data bit may be assigned as a type I error position 134 when a specific column *cᵢ* is employed or as a type II error position 136 when a different column *cⱼ, j* ≠ *i* may be used. This embodiment also requires employing a number of error detection units 114 preferably being equal to the number *n* of the diagonalization units 112, wherein the error detection units 114 may comprise a common minimum determining unit 146. Since it is generally much easier to correct type I error positions 134 with respect to type II error positions 136, the performance of the error correction according to the present invention may, thus, additionally be enhanced.

In order to further enhance the performance of the error correction facility of the method and the device according to the present invention, each error detection unit 114 herein may be adapted to determining, in particular simultaneously, more than exactly one type II error position 136 within the block code and may, therefore, be arranged in a manner similar to the embodiment as schematically depicted in Figure 3.

### List of reference numbers

- 110: error correction device
- 112: diagonalization unit
- 114: error detection unit
- 116: error correction unit
- 118: first input port of the diagonalization unit
- 120: second input port of the diagonalization unit
- 122: output port of the diagonalization unit
- 124: first input port of the error detection unit
- 126: second input port of the error detection unit
- 128: output port of the error detection unit
- 130: error position in the block code
- 132: input port of the error correction unit
- 134: type I error position in the block code
- 136: type II error position in the block code
- 138: XOR gate
- 140: multiplexer
- 142: look-up table
- 144: weighing unit
- 146: extremum (minimum) determining unit
- 148: storage unit

## Claims

1. A method for an error correction of transmitted data, wherein the transmitted data are encoded in a block code, wherein the block code comprises a number of data bits and an additional number of redundant bits, wherein the block code is described by a parity-check matrix **H,** wherein columns of the parity-check matrix **H** are inherently related to the data bits of the block code, the method comprising the following steps:
(a) diagonalizing the parity-check matrix **H,** with respect to at least one column of the parity-check matrix **H,** into a diagonalized parity-check matrix **H',** wherein the diagonalized parity-check matrix **H'** is related to the block code and to the at least one column;
(b) determining at least one error position (130) in the block code by using the diagonalized parity-check matrix **H'** and a syndrome vector, wherein the syndrome vector is related to the data bits in the block code;
(c) performing the error correction of the transmitted data at the at least one error position (130) in the block code.

2. The method according to the preceding claim, wherein, in step (a), the at least one column of the parity-check matrix **H** is selected according to a reliability information related to the data bits of the block code.

3. The method according to any one of the preceding claims, wherein, in step (b), the at least one error position (130) is assigned to one of a type I error position (134) and a type II error position (136), wherein the type I error position (134) is located within a diagonalized part of the diagonalized parity-check matrix **H',** and wherein the type II error position (136) is located within a non-diagonalized part of the diagonalized parity-check matrix **H'.**

4. The method according to the preceding claim, wherein, in step (b), the at least one type I error position (134) is determined by locating at least one 'true' entry in the syndrome vector.

5. The method according to any one of the two preceding claims, wherein, in step (b), one type II error position (136) is determined by comparing the syndrome vector with the at least one column of the diagonalized parity-check matrix **H',** wherein the type II error position (136) is selected from the at least one column of the diagonalized parity-check matrix **H'** which is considered as being most similar to the syndrome vector.

6. The method according to the preceding claim, wherein one of the at least one column vectors of the diagonalized parity-check matrix **H'** and the syndrome vector are component-wise submitted to a binary XOR operation, thereby providing a resulting vector for each component, wherein, subsequently, the resulting vectors are weighted, and wherein an extremum of the weighted resulting vectors constitutes the type II error position (136).

7. The method according to any one of the four preceding claims, wherein, in step (b), at least one type II error position (136) is determined by storing at least one column of the diagonalized parity-check matrix **H'** as at least one stored column and comparing the syndrome vector with the at least one stored column.

8. The method according to any one of the preceding claims, wherein, in step (a), at least two different kinds of diagonalizations of the diagonalized parity-check matrix **H'** are provided for determining, in step (b), at least two error positions (130).

9. A device (110) for an error correction of transmitted data, wherein the transmitted data are encoded in a block code, wherein the block code comprises a number of data bits and an additional number of redundant bits, wherein the block code is described by a parity-check matrix **H,** wherein columns of the parity-check matrix **H** are inherently related to the data bits of the block code, the device (110) comprising:
(A) a diagonalization unit (112) for performing a diagonalization of at least one column of the parity-check matrix **H** of the block code into a diagonalized parity-check matrix **H';**
(B) an error detection unit (114) for determining at least one error position (130) in the block code by using the diagonalized parity-check matrix **H'** and a syndrome vector; and
(C) an error correction unit (116) for performing the error correction of the transmitted data at the at least one error position (130) in the block code.

10. The device (110) according to the preceding claim, wherein the error detection unit (114) comprises a look-up table (142) for inserting at least one 'true' binary value of the syndrome vector, wherein the at least one 'true' binary value provides at least one type I error position (134) in the block code, wherein the at least one type I error position (134) is located within a diagonalized part of the diagonalized parity-check matrix **H'.**

11. The device (110) according to any one of the preceding device claims, wherein the error detection unit (114) further comprises at least one XOR gate (138) for a component-wise submitting one of the at least one column vector of the diagonalized parity-check matrix **H'** and the syndrome vector to a binary XOR operation to acquiring at least one resulting vector, at least one weighing unit (144) for weighing the at least one resulting vector, and at least one extremum determining unit (146) for determining an extremum of the at least one weighted resulting vector, wherein the extremum provides a type II error position (136), wherein the type II error position (136) is located within a non-diagonalized part of the diagonalized parity-check matrix **H'.**

12. The device (110) according to the preceding claim, wherein the error detection unit (114) further comprises at least one storage unit (148) for storing at least one stored column, wherein the stored column comprises one column of the diagonalized parity-check matrix **H'** or a sum of at least two columns of the diagonalized parity-check matrix **H'** or a sum of at least one column of the diagonalized parity-check matrix **H'** with the syndrome vector **s**, and at least one comparing unit for comparing the syndrome vector with the at least one stored column, wherein the comparing provides the at least one type II error position (136).

13. A use of the device according to any one of the preceding device claims for an error correction of transmitted data, wherein the data are transmitted by a communication system, wherein the communication system comprises one or more of a DSL, a DAB, a DVB, a satellite, a deep-space, an optical, and a mobile communication system, and/or wherein the data are transmitted to or from a storage system, wherein the storage system comprises one or more of a hard disk, a flash disk, and an optical storage system.

14. A computer program including computer-executable instructions for performing the method according to any one of the preceding method claims, when the program is executed on a computer or computer network.

15. A data carrier having a data structure stored thereon, which, after loading into a computer or computer network, is capable of executing the method according to any one of the preceding method claims.
